# EUROPEAN PATENT SPECIFICATION

(11) **EP 3 696 693 B1**
(45) Date of publication and mention of the grant of the patent: **02.04.2025**
(21) Application number: 17928343.7
(22) Date of filing: 10.10.2017
(51) Int. Cl.: G05B 23/02

(54) **METHOD AND APPARATUS FOR MONITORING STATE OF DEVICE IN PROCESS INDUSTRY AND MEDIUM**
VERFAHREN UND VORRICHTUNG ZUR ÜBERWACHUNG DES ZUSTANDES EINER VORRICHTUNG IN DER PROZESSINDUSTRIE UND MEDIUM
PROCÉDÉ ET APPAREIL DE SURVEILLANCE DE L'ÉTAT D'UN DISPOSITIF DANS L'INDUSTRIE DE TRAITEMENT ET SUPPORT

(43) Date of publication of application: 19.08.2020
(73) Proprietor: Siemens Aktiengesellschaft, 80333 München (DE)
(72) Inventor: WU, Wenchao, Shanghai 200120 (CN); XU, Bingyao, Shanghai 200090 (CN); LUO, Wenxian, Shanghai 200090 (CN)
(74) Representative: Isarpatent
(86) International application number: PCT/CN2017/105572
(87) International publication number: WO 2019/071438

(56) References cited:
- WO-A1-2017/101317
- CN-A- 104 102 773
- CN-A- 105 787 809
- CN-A- 106 203 642
- CN-A- 106 228 472
- US-A1- 2006 184 264
- US-A1- 2012 041 575
- US-A1- 2014 201 571
- US-A1- 2014 244 192
- US-A1- 2015 094 988

## Description

### Technical Field

The present invention relates to the technical field of device monitoring in a process industry, and in particular relates to a method and apparatus for monitoring the state of a device in a process industry and a computer storage medium.

### Background Art

US 2014/201571 A1, BROOKS AUTOMATION INC, 17 July 2014, relates to an intelligent condition monitoring and fault diagnostic system for preventative maintenance.

US 2014/244192 A1, INSCOPE ENERGY LLC, 28 August 2014, relates to a system and method for providing a monitoring of industrial equipment.

US 2012/0041575 A1, February 16, 2012, relates to an anomaly detection method.

Equipment maintenance is the most important in the manufacturing industry. Improper equipment maintenance and any equipment fault will lead to a low efficiency and a high safety risk and especially cannot be borne in a process industry.

Once formed, a product is difficult to recover in a process industry. That is to say, the product cannot be disassembled once assembled. Physical or chemical methods such as mixing, separation, pulverization and heating are mainly used for raw materials in a process industry to increase the value of raw materials. Typical process industries include the pharmaceutical industry, the chemical industry, the petrochemical industry, the power industry, the steelmaking industry, the energy industry, the cement industry, the food industry, the beverage industry, etc. Enterprises in the process industries mainly adopt the make-to-stock, batch and continuous production methods.

The equipment of an enterprise in the process industries is a fixed production line with a large investment and a fixed process flow. The equipment has a limited production capacity. The maintenance of equipment in the production line is especially important and no fault is allowed. An equipment fault in the process industries will lead to a forced stop of the production process which involves many chemical reactions, and most intermediate products produced from incomplete reactions caused by the production stop will be discarded only as rejects. The incurred losses of raw materials and energy are enormous. In addition, in most cases, the equipment needs to be restarted after a production stop, and it will take the equipment some time to get stabilized and the efficiency and the safety will be influenced. Therefore, it is necessary to online monitor the state of the equipment so as to reduce unplanned stops by detecting the "health" problem of the equipment as early as possible.

However, it is very difficult to determine the health condition of the online equipment or obtain the fixed rules for monitoring the lifecycle state of the equipment, especially in a process industry where complex and highly sensitive correlations between a large number of variables are involved, because of a lack of an accurate definition of the boundary between the normal and abnormal equipment states.

Most manufacturers still perform planned routine maintenances, and in this case, the equipment runs until a scheduled maintenance time. This policy is non-real-time and highly dependent on experience. As a result, an excess of maintenances is caused because the maintenance time tends to be selected before any potential fault or a lack of maintenances is caused because it is almost impossible to provide all different fault modes in advance.

### Summary of the Invention

In view of this, one object of the present invention is to provide a method for monitoring the state of a device in a process industry to realize the online monitoring of the state of the device in the process industry;
another object of the present invention is to provide an apparatus for monitoring the state of a device in a process industry to realize the online monitoring of the state of the device in the process industry;
a further object of the present invention is to provide a computer storage medium to realize the online monitoring of the state of a device in a process industry.

To achieve the above-mentioned objects, the following technical solutions are provided in the present invention:
A method according to claim 1 is provided.

After obtaining the correlated state dimensions, the method further comprises:
outputting the obtained correlated state dimensions to the user, and if receiving modification information input by the user about the correlated state dimensions, modifying the correlated state dimensions according to the modification information.

After obtaining the device state reference model, the method further comprises:
outputting the obtained device state reference model to the user, and if receiving modification information input by the user about the device state reference model, modifying the device state reference model according to the modification information.

The correlation analysis algorithm is the Pearson correlation algorithm and/or the Kendall correlation algorithm, and
the algorithm for establishing a device state reference model is the Dirichlet process algorithm based on the Gaussian mixture model.

Also provided is an apparatus according to claim 6.

The data acquisition module collecting and saving data of the multi-dimensional states of a device in a process industry is specifically used to
collect data of the multi-dimensional states of the device in the process industry from one or any combination of the manufacturing data acquisition system, the supervisory control and data acquisition system and the simulation system and save the data,
or collect data of the multi-dimensional states of the device in the process industry from one or any combination of the manufacturing data acquisition system, the supervisory control and data acquisition system and the simulation system, and the device design system and save the data.

The apparatus further comprises a man-machine interaction module, and
the correlation calculation module is further used to output the obtained correlated state dimensions to the user through the man-machine interaction module, and if receiving modification information input by the user about the correlated state dimensions from the man-machine interaction module, modify the correlated state dimensions according to the modification information.

The apparatus further comprises a man-machine interaction module, and
the state reference establishment module is further used to output the obtained device state reference model to the user through the man-machine interaction module, and if receiving modification information input by the user about the device state reference model from the man-machine interaction module, modify the device state reference model according to the modification information.

A computer readable storage medium according to claim 10 and a computer program according to claim 11 are also provided.

An apparatus for monitoring the state of a device in a process industry comprises a processor and a memory, and
applications, which can be executed by the processor to enable the processor to perform the steps of the above-mentioned method for monitoring the state of a device in a process industry, are stored in the memory.

From the above-mentioned technical solutions, it can be seen that in the present invention, the correlated state dimensions are obtained by performing a correlation analysis of history data of the multi-dimensional states of a device, then a device state reference model is established by using the history data of the correlated dimensional states, and finally the device state reference model is used to determine the real-time data of the correlated dimensional states to determine whether the state of the device is normal, thus realizing the online monitoring of the state of the device.

### Brief Description of the Drawings

The following detailed description in combination with the drawings will make more obvious other characteristics, features and advantages of the present invention.
Fig. 1 is a flowchart of the method for monitoring the state of a device in a process industry in one embodiment of the present invention.
Fig. 2 shows the structure of the apparatus for monitoring the state of a device in a process industry in one embodiment of the present invention.
Fig. 3 is a flowchart of the method executed by the apparatus in Fig. 2 to monitor the state of a device in a process industry in the embodiments of the present invention.
Fig. 4 shows the structure of the apparatus for monitoring the state of a device in a process industry in another embodiment of the present invention.

### Description of reference numerals in the drawings:

| Reference numeral | Meaning |
|---|---|
| 101-104 | Steps |
| 20 | Apparatus I for monitoring the state of a device in a process industry |
| 21 | Data acquisition module |
| 22 | Correlation calculation module |
| 23 | State reference model establishment module |
| 24 | Online monitoring module |
| 25 | Man-machine interaction module |
| 301-304 | Steps |
| 40 | Apparatus II for monitoring the state of a device in a process industry |
| 41 | Processor |
| 42 | Memory |

### Detailed Description of the Invention

To make clearer the objects, technical solutions and advantages of the present invention, the following further describes in detail the present invention in combination with the drawings and embodiments.

"One" or "the" in the singular form in the description or claims of the present invention is also intended to cover the plural form, unless otherwise explicitly specified in the document.

The method for monitoring the state of a device in a process industry provided by the present invention comprises: collecting and saving data of the multi-dimensional states of a device in a process industry; adopting a preset correlation analysis algorithm to perform a correlation analysis of the collected history data of the multi-dimensional states of the device to obtain the correlated state dimensions; acquiring history data of correlated dimensional states according to the obtained correlated state dimensions and adopting a preset algorithm for establishing a device state reference model to model the acquired history data of correlated dimensional states to obtain the device state reference model; acquiring real-time data of the corresponding correlated dimensional states of the device state reference model in real time and determining whether the current state of the device is normal according to a preset device state determination condition, the real-time data of the correlated dimensional states and the device state reference model.

The step of collecting and saving data of the multi-dimensional states of a device in a process industry can comprise collecting data of the multi-dimensional states of the device in the process industry from one or any combination of the manufacturing data acquisition system, the supervisory control and data acquisition system, and the simulation system and saving the data, or collecting data of the multi-dimensional states of the device in the process industry from one or any combination of the manufacturing data acquisition system, the supervisory control and data acquisition system and the simulation system, and the device design system and saving the data.

In order to obtain the more accurate result of the correlated state dimensions, after obtaining the correlated state dimensions, the method further comprises outputting the obtained correlated state dimensions to the user, and if receiving modification information input by the user about the correlated state dimensions, modifying the correlated state dimensions according to the modification information.

In order to obtain a more accurate device state reference model, after obtaining the device state reference model, the method further comprises outputting the obtained device state reference model to the user, and if receiving modification information input by the user about the device state reference model, modifying the device state reference model according to the modification information.

Wherein, the correlation analysis algorithm can be the Pearson correlation algorithm and/or the Kendall correlation algorithm, and the algorithm for establishing a device state reference model can be the Dirichlet process algorithm based on the Gaussian mixture model.

The apparatus for monitoring the state of a device in a process industry provided by the present invention comprises: a data acquisition module, collecting and saving data of the multi-dimensional states of a device in a process industry, a correlation calculation module, adopting a preset correlation analysis algorithm to perform a correlation analysis of the history data collected by the data acquisition module of the multi-dimensional states of the device to obtain the correlated state dimensions, a state reference model establishment module, acquiring history data of correlated dimensional states from the data acquisition module according to the correlated state dimensions obtained by the correlation calculation module and adopting a preset algorithm for establishing a device state reference model to model the acquired history data of correlated dimensional states to obtain the device state reference model, and an online monitoring module, acquiring real-time data of the corresponding correlated dimensional states of the device state reference model in real time from the data acquisition module according to the device state reference model established by the state reference model establishment module and determining whether the current state of the device is normal according to a preset device state determination condition, the real-time data of the correlated dimensional states and the device state reference model.

Wherein, the data acquisition module collecting and saving data of the multi-dimensional states of a device in a process industry is specifically used to collect data of the multi-dimensional states of the device in the process industry from one or any combination of the manufacturing data acquisition system, the supervisory control and data acquisition system and the simulation system and save the data, or collect data of the multi-dimensional states of the device in the process industry from one or any combination of the manufacturing data acquisition system, the supervisory control and data acquisition system and the simulation system, and the device design system and save the data.

The apparatus further comprises a man-machine interaction module, and the correlation calculation module is further used to output the obtained correlated state dimensions to the user through the man-machine interaction module, and if receiving modification information input by the user about the correlated state dimensions from the man-machine interaction module, modify the correlated state dimensions according to the modification information.

The apparatus further comprises a man-machine interaction module and the state reference establishment module is further used to output the obtained device state reference model to the user through the man-machine interaction module, and if receiving modification information input by the user about the device state reference model from the man-machine interaction module, modify the device state reference model according to the modification information.

The computer readable storage medium provided by the present invention stores a computer program and the computer program performs the steps of the above-mentioned method for monitoring the state of a device in a process industry when executed by a processor.

Another device for monitoring the state of a device in a process industry provided by the present invention comprises a processor and a memory, and applications, which can be executed by the processor to enable the processor to perform the steps of the above-mentioned method for monitoring the state of a device in a process industry, are stored in the memory.

The present invention is described in detail below.

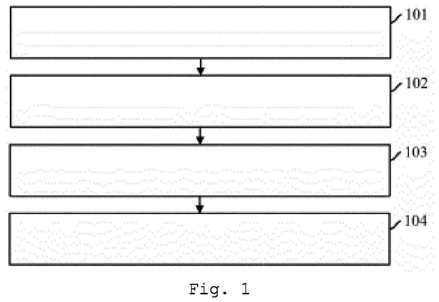

Fig. 1 is a flowchart of the method for monitoring the state of a device in a process industry in one embodiment of the present invention, and the specific steps are as follows:
Step 101: Collect and save data of the multi-dimensional states of a device in a process industry.

Specifically, data of the multi-dimensional states of the device in the process industry can be collected from one or any combination of the manufacturing data acquisition system, the supervisory control and data acquisition system and the simulation system and can be saved, or data of the multi-dimensional states of the device in the process industry can be collected from one or any combination of the manufacturing data acquisition system, the supervisory control and data acquisition system and the simulation system, and the device design system and can be saved.

Here, the data of each dimensional state corresponds to a time sequence data flow for describing a state of a device. For example, if n sensors (for example, a temperature sensor, a vibration sensor, a pressure sensor, etc.) are deployed on a device to detect a plurality of states of a plurality of components of the device, data of n dimensional states of the device will be collected.

Step 102: Adopt a preset correlation analysis algorithm to perform a correlation analysis of the collected history data of the multi-dimensional states of the device to obtain the correlated state dimensions.

The correlation analysis algorithm is, for example, the Pearson correlation algorithm or the Kendall correlation algorithm.

For example, data of n dimensional states of a device is collected, it is learned that data of m (m≤n) dimensional states is correlated after a correlation analysis, and the dimensional values of the m dimensional states are 1, 3, 4, 8..., respectively.

According to the invention, one of the dimensional states is used as a target state, and then a correlation analysis algorithm is used to analyze which dimensional states are correlated to the target state.

Step 103: Acquire history data of correlated dimensional states according to the obtained correlated state dimensions and adopt a preset algorithm for establishing a device state reference model to model the acquired history data of correlated dimensional states to obtain the device state reference model.

The algorithm for establishing a device state reference model is, for example, the Dirichlet process algorithm based on the Gaussian mixture model.

For example, if it is learned from the analysis by use of a correlation analysis algorithm that a plurality of state dimensions correlated to a target state dimension (for example, state dimension p) are dimensions q, u and v, respectively, then an attempt is made to establish a mapping when the device state reference model is established. In the mapping, history data of state dimensions q, u and v is used as input parameters and history data of state dimension p is used as output parameter. The mapping is the device state reference model, that is to say, the device state reference model depicts the relationship between state dimension p and state dimensions q, u and v.

A device state reference model can be established for each target state dimension of different target state dimensions of a device.

Step 104: Acquire real-time data of the corresponding correlated dimensional states of the device state reference model in real time according to the device state reference model and determine whether the current state of the device is normal according to a preset device state determination condition, the real-time data of the correlated dimensional states and the device state reference model.

For example, real-time data of state dimensions p, q, u and v is acquired in real time according to the device state reference model established to depict the relationship between state dimension p and state dimensions q, u and v, then real-time data of state dimensions q, u and v is input into the device state reference model for calculations to obtain an expected data value of state dimension p, the difference between the expected data value of state dimension p and the real-time acquired actual data value of state dimension p is calculated, it is determined whether the difference is less than a preset threshold, if yes, the state of dimension p is considered normal, and otherwise, the state of dimension p is considered abnormal.

The device state determination condition can be: if the difference between the expected data value of the device target state obtained through calculations according to the device state reference model and the actual data value of the device target state is less than a preset threshold, the device target state is considered normal, and otherwise, the device target state is considered abnormal. The specific device state determination condition can be set by the user according to the application scenario.

Specifically, after the current state of a device is determined to be normal or abnormal, the determined current state of the device can be output to the user, and the user can modify the current state of the device according to experience. If the user modifies the current state of the device according to experience, the corresponding device state reference model can be considered inaccurate, and the real-time data acquired in Step 104 of corresponding correlated dimensional states of the device state reference model is used as history data to re-establish a device state reference model.

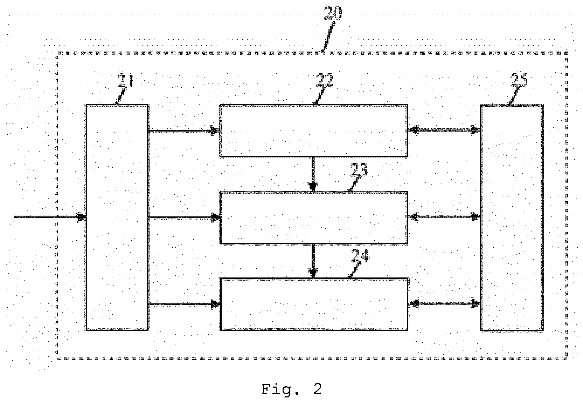

Fig. 2 shows the structure of the apparatus 20 for monitoring the state of a device in a process industry in one embodiment of the present invention, and the apparatus 20 comprises a data acquisition module 21, a correlation calculation module 22, a state reference model establishment module 23, an online monitoring module 24 and a man-machine interaction module 25.

The data acquisition module 21 collects and saves data of the multi-dimensional states of a device in a process industry.

In practical applications, the data acquisition module 21 can collect data of the multi-dimensional states of the device in the process industry from one or any combination of the manufacturing data acquisition system, the supervisory control and data acquisition system and the simulation system and save the data, or collect data of the multi-dimensional states of the device in the process industry from one or any combination of the manufacturing data acquisition system, the supervisory control and data acquisition system and the simulation system, and the device design system and save the data.

The correlation calculation module 22 adopts a preset correlation analysis algorithm to perform a correlation analysis of the history data collected by the data acquisition module 21 of the multi-dimensional states of the device to obtain the correlated state dimensions.

In practical applications, the apparatus 20 can further comprise a man-machine interaction module 25, and the correlation calculation module 22 is further used to output the obtained correlated state dimensions to the user through the man-machine interaction module 25, after that, if receiving modification information input by the user about the correlated state dimensions, the man-machine interaction module 25 sends the modification information to the correlation calculation module 22, and the correlation calculation module 22 modifies the correlated state dimensions according to the modification information.

The state reference model establishment module 23 acquires history data of correlated dimensional states from the data acquisition module 21 according to the correlated state dimensions obtained by the correlation calculation module 22 and uses a preset algorithm for establishing a device state reference model to model the acquired history data of correlated dimensional states to obtain the device state reference model.

In practical applications, the apparatus 20 can further comprise a man-machine interaction module 25, and the state reference model establishment module 23 is further used to output the obtained device state reference model to the user through the man-machine interaction module 25, after that, if receiving modification information input by the user about the device state reference model, the man-machine interaction module 25 sends the modification information to the state reference model establishment module 23, and the state reference model establishment module 23 modifies the device state reference model according to the modification information.

The online monitoring module 24 acquires real-time data of the corresponding correlated dimensional states of the device state reference model in real time from the data acquisition module 21 according to the device state reference model established by the state reference model establishment module 23 and determines whether the current state of the device is normal according to a preset device state determination condition, the real-time data of the correlated dimensional states and the device state reference model.

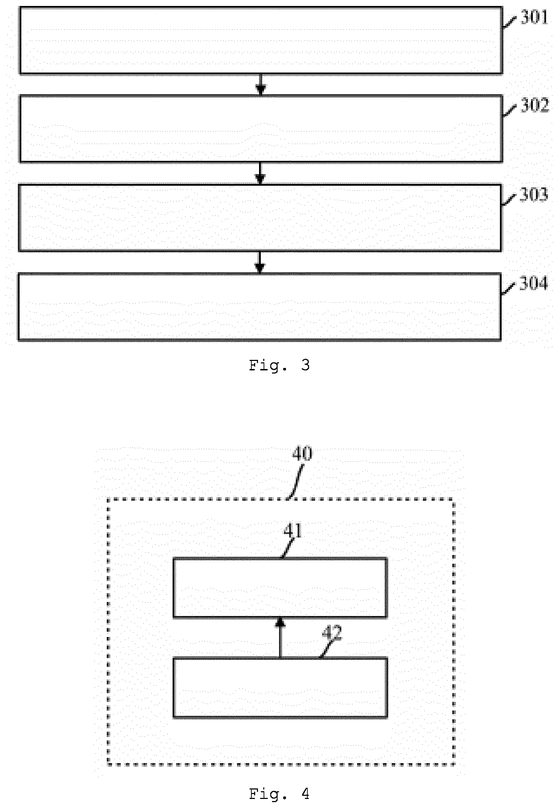

Fig. 3 is a flowchart of the method executed by the apparatus 20 in Fig. 2 to monitor the state of a device in a process industry in the embodiments of the present invention, and the specific steps are as follows:
Step 301: The data acquisition module 21 periodically collects and saves data of the multi-dimensional states of a device in a process industry.

Specifically, the data acquisition module 21 can collect data of the multi-dimensional states of a device in a process industry from the following systems:

### 1. Manufacturing data acquisition system, for example, distributed control system (DCS).

The manufacturing data acquisition system collects data of the multi-dimensional states of the device from various sensors and/or various measuring instruments on the device in real time, and then only needs to send the collected data of the multi-dimensional states of the device to the data acquisition module 21 in real time, wherein the time sequence data flow collected from each sensor or measuring instrument is used as data of a dimensional state.

For example, for the DCS in the petrochemical industry, the collected data of the multi-dimensional states of a device can contain:
(11) Temperature data collected from temperature sensors on the device, wherein the specific DCS needs to record the collection time, the IDs/Nos. of the temperature sensors and the corresponding temperature values
(12) Vibration data collected from vibration sensors on the device, wherein the specific DCS needs to record the collection time, the IDs/Nos. of the vibration sensors and the corresponding vibration values (for example, flags indicating whether vibrations occur)
(13) Pressure values collected from pressure sensors on the device, wherein the specific DCS needs to record the collection time, the IDs/Nos. of the pressure sensors and the corresponding pressure values
(14) Valve opening values collected from valve opening sensors on the device, wherein the specific DCS needs to record the collection time, the IDs/Nos. of the valve opening sensors and the corresponding valve opening values.

### 2. Supervisory control and data acquisition (SCADA) system

The SCADA system collects data of the multi-dimensional states of the device from various sensors and/or various measuring instruments on the device in real time, and then only needs to send the collected data of the multi-dimensional states of the device to the data acquisition module 21 in real time.

For example, for the SCADA system in the hydropower industry, the collected data of the multi-dimensional states of a device can contain:
(21) Current values collected from ammeters on the device, wherein the specific SCADA system needs to record the collection time, the IDs/Nos. of the ammeters and the corresponding current values.
(22) Voltage values collected from voltmeters on the device, wherein the specific SCADA system needs to record the collection time, the IDs/Nos. of the voltmeters and the corresponding voltage values.

### 3. Device design system

For the device design system, the data collected by the data acquisition module 21 of the multi-dimensional states of a device can contain:
(31) Distance between sensors on the device
(32) Length of pipelines on the device
(33) Design data of pipelines on the device, for example, shapes and dimensions of components of the pipelines, connections between components and distances between components.

### 4. Simulation system

Sometimes, the simulation system can be utilized to simulate the actual production process, and in this case, the data acquisition module 21 can directly collect the required data of the multi-dimensional states of a device.

Step 302: The correlation analysis module 22 adopts a preset correlation analysis algorithm to perform a correlation analysis of the collected history data of the multi-dimensional states of the device to obtain a correlation indicator vector, wherein the correlation indicator vector indicates the correlated state dimensions and the description of the correlation between the correlated dimensional states.

It should be noted that when a correlation analysis is performed for the collected history data of the multi-dimensional states of the device in this step, the state dimensions can be based on the collected object of the state data, for example, the state data coming from each collected object such as sensor or measuring instrument is used as data of a dimensional state.

The time range of history data can be set by the user and can be a recent month or a recent year, for example.

For example, when the correlation calculation module 22 performs a correlation analysis of history data of n (n is an integer greater than 1) dimensional states of the device, the obtained correlation indicator vector indicates that m (m is an integer greater than 1 but less than or equal to n) dimensional states are correlated and the correlation indicator vector contains a description of the correlation between m dimensional states.

The description of the correlation between correlated dimensional states can be as follows: A change of a dimensional state or multi-dimensional states will cause a change to another dimensional state or other multi-dimensional states. For example, when a first change happens to the state of dimension a in a first time, a second change will be caused to the state of dimension b in a second time, a third change will be caused to the state of dimension c in a third time, ..., wherein the first time, the second time, the third time, ..., can be a time point or a time range.

For example, if the state dimensions related to the vibrations in a position of a pump need be analyzed, the correlation calculation module 22 performs a correlation analysis of the history data of vibrational state of dimension a collected by the data acquisition module 21 from the vibration sensor (sensor A) in the position and the history data of the states collected from other sensors on the pump, and finally learns that the states of corresponding dimensions b, d and f of sensors B, D and F are correlated to the vibrational state of dimension a of sensor A and obtains the description (for example, how long and what change will happen to the data of the states of dimensions b, d and f output from sensors B, D and F after sensor A detects that the vibrational state of dimension a is intensified: e.g. the temperature output from sensor B will rise in 0 to 10ms after sensor A detects that the vibration is intensified) about the correlation between the states of dimensions b, d and f and the state of dimension a.

In practical applications, the user can set a target state dimension for a correlation analysis on the correlation calculation module 22, and the correlation calculation module 22 will calculate the dimensions related to the target state dimension according to the collected history data of all state dimensions of the device.

Wherein, the correlation analysis algorithm is, for example, the Pearson correlation algorithm or the Kendall correlation algorithm. The correlation analysis algorithm is not restricted in the present invention and can be preset in advance according to experience and the scenario.

In addition, the user further needs to configure some configuration parameters necessary for a correlation analysis on the correlation calculation module 22, for example, configure the time range (for example, in a recent month or a recent year) of history data of a state, and a correlation determination threshold (for example, when the correlation between two state dimensions is greater than a first threshold, the two state dimensions are determined to be correlated, and otherwise, the two state dimensions are not correlated).

After the correlation calculation module 22 obtains a correlation indicator vector, the correlation indicator vector can be output through the man-machine interaction module 25, and the user can modify the correlation indicator vector (for example, delete a part of state dimensions from the correlation indicator vector or add other state dimensions to the correlation indicator vector) according to his/her own judgment, or the user can change the values of a part or all of the configuration parameters of the correlation analysis algorithm through the man-machine interaction module 25 and trigger the correlation calculation module 22 to perform a correlation analysis again until the user is satisfied with the output correlation indicator vector.

Step 303: The state reference model establishment module 23 determines the correlated state dimensions according to the correlation indicator vector generated by the correlation calculation module 22, acquires history data of correlated dimensional states from the data acquisition module 21, and uses a preset algorithm for establishing a device state reference model to model the acquired history data of correlated dimensional states to obtain the device state reference model.

For example, if the correlation indicator vector generated by the correlation calculation module 22 indicates that m dimensional states of the device are correlated, the state reference model establishment module 23 acquires history data of m dimensional states from the data acquisition module 21. The time range of history data can be set by the user.

The algorithm for establishing a device state reference model is, for example, the Dirichlet process algorithm based on the Gaussian mixture model. The algorithm for establishing a device state reference model is not restricted in the present invention and can be preset in advance according to experience and the scenario.

In addition, the user further needs to configure some configuration parameters necessary for the algorithm for establishing a device state reference model on the state reference model establishment module 23, for example, configure the time range (for example, in a recent month or a recent year) of history data of a state.

Likewise, after the state reference model establishment module 23 obtains the device state reference model, the device state reference model can be output to the user through the man-machine interaction module 25, and the user can modify the device state reference model through the man-machine interaction module 25, or the user can change the values of a part or all of the configuration parameters of the algorithm for establishing a device state reference model through the man-machine interaction module 25 and trigger the state reference model establishment module 23 to re-establish a device state reference model until the user is satisfied with the output device state reference model.

Step 304: The online monitoring module 24 acquires real-time data of the corresponding correlated dimensional states of the model from the data acquisition module 21 in real time according to the established device state reference model and determines whether the current state of the device is normal according to a preset device state determination condition, the real-time data of the correlated dimensional states and the device state reference model.

Likewise, after the online monitoring module 24 obtains the device state monitoring result (normal or abnormal), the device state monitoring result can be output to the user through the man-machine interaction module 25, and the user can modify the device state monitoring result through the man-machine interaction module 25 according to experience. If the user modifies the current state of the device according to experience, the corresponding device state reference model can be considered inaccurate, and the real-time data acquired in Step 104 of corresponding correlated dimensional states of the device state reference model is used as history data to re-establish a device state reference model.

Considering that the aging of a device will cause the production capacity of the device to change, steps 301 to 303 can be performed at intervals, for example, once a month, to continuously update the device state reference model, or can be performed at any time according to the requirements of the user.

Fig. 4 shows the structure of the apparatus 40 for monitoring the state of a device in a process industry in another embodiment of the present invention, and the apparatus comprises a processor 41 and a memory 42, wherein
applications are stored in the memory 42, which applications can be executed by the processor 41 to enable the processor 41 to perform the following steps of the method for monitoring the state of a device in a process industry:
collect and save data of the multi-dimensional states of a device in a process industry;
adopt a preset correlation analysis algorithm to perform a correlation analysis of the collected history data of the multi-dimensional states of the device to obtain the correlated state dimensions;
acquire history data of correlated dimensional states according to the obtained correlated state dimensions and adopt a preset algorithm for establishing a device state reference model to model the acquired history data of correlated dimensional states to obtain the device state reference model;
acquire real-time data of the corresponding correlated dimensional states of the device state reference model in real time and determine whether the current state of the device is normal according to a preset device state determination condition, the real-time data of the correlated dimensional states and the device state reference model.

In practical applications, the step performed by the processor 41 of collecting and saving data of the multi-dimensional states of a device in a process industry in real time specifically comprises:
collecting data of the multi-dimensional states of the device in the process industry from one or any combination of the manufacturing data acquisition system, the supervisory control and data acquisition system and the simulation system and saving the data, or collecting data of the multi-dimensional states of the device in the process industry in real time from one or any combination of the manufacturing data acquisition system, the supervisory control and data acquisition system and the simulation system, and the device design system and saving the data.

In practical applications, after obtaining the correlated state dimensions, the processor 41 further performs the following step:
output the obtained correlated state dimensions to the user, and if receiving modification information input by the user about the correlated state dimensions, modify the correlated state dimensions according to the modification information.

In practical applications, after obtaining the device state reference model, the processor 41 further performs the following step:
output the obtained device state reference model to the user, and if receiving modification information input by the user about the device state reference model, modify the device state reference model according to the modification information.

In practical applications, the correlation analysis algorithm is the Pearson correlation algorithm and/or the Kendall correlation algorithm, and the algorithm for establishing a device state reference model is the Dirichlet process algorithm based on the Gaussian mixture model.

The present invention further provides a computer readable storage medium, the computer readable storage medium stores a computer program and the computer program performs the following steps of the method for monitoring the state of a device in a process industry when executed by a processor:
collect and save data of the multi-dimensional states of a device in a process industry;
adopt a preset correlation analysis algorithm to perform a correlation analysis of the collected history data of the multi-dimensional states of the device to obtain the correlated state dimensions;
acquire history data of correlated dimensional states according to the obtained correlated state dimensions and adopt a preset algorithm for establishing a device state reference model to model the acquired history data of correlated dimensional states to obtain the device state reference model;
acquire real-time data of the corresponding correlated dimensional states of the device state reference model in real time and determine whether the current state of the device is normal according to a preset device state determination condition, the real-time data of the correlated dimensional states and the device state reference model.

In practical applications, the step performed by the computer program of collecting and saving data of the multi-dimensional states of a device in a process industry in real time specifically comprises:
collecting data of the multi-dimensional states of the device in the process industry from one or any combination of the manufacturing data acquisition system, the supervisory control and data acquisition system and the simulation system and saving the data, or collecting data of the multi-dimensional states of the device in the process industry in real time from one or any combination of the manufacturing data acquisition system, the supervisory control and data acquisition system and the simulation system, and the device design system and saving the data.

In practical applications, when executed by a processor, the computer program further performs the following step:
output the obtained correlated state dimensions to the user, and if receiving modification information input by the user about the correlated state dimensions, modify the correlated state dimensions according to the modification information.

In practical applications, when executed by a processor, the computer program further performs the following step:
output the obtained device state reference model to the user, and if receiving modification information input by the user about the device state reference model, modify the device state reference model according to the modification information.

In practical applications, the correlation analysis algorithm is the Pearson correlation algorithm and/or the Kendall correlation algorithm, and the algorithm for establishing a device state reference model is the Dirichlet process algorithm based on the Gaussian mixture model.

The advantages of the prevent invention are as follows:
Online monitoring of the state of a device is realized;
semi-supervision is adopted and the visualization aided interactive knowledge discovery is supported so that users, for example, device operators/engineers, can combine their experience/domain knowledge to participate in the whole device state monitoring process and construct adaptive and robust device state reference models under different environments.

## Claims

1. A method for monitoring the state of a device in a process industry, **characterized in that** the method comprises:
collecting and saving (S101) data of multi-dimensional states of a device in the process industry;
adopting (S102) a preset correlation analysis algorithm to perform a correlation analysis of the collected data of the multi-dimensional states of the device to obtain correlated dimensional state, wherein a dimensional state is used as a target state and the correlation analysis algorithm is used to analyze which of the dimensional states are correlated to the target state;
acquiring (S103) history data of correlated dimensional states according to the obtained correlated state dimensions;
adopting (S103) a preset algorithm to model the acquired history data of correlated dimensional states to obtain a device state reference model;
acquiring (S104) real-time data of correlated dimensional states of the device state reference model in real time; and
determining (S104) whether a current state of the device is normal wherein, if the difference between a data value of a target state calculated according to the device state reference model from the real-time data and an actual target state data value is less than a preset threshold, the target state is considered normal, otherwise, the target state is abnormal.

2. The method for monitoring the state of a device in a process industry as claimed in claim 1, **characterized in that** the step of collecting and saving (S101) data of the multi-dimensional states of a device in a process industry comprises:
collecting data of the multi-dimensional states of the device in the process industry from one or any combination of a manufacturing data acquisition system, a supervisory control and data acquisition system and a simulation system, and a device design system and saving the data.

3. The method for monitoring the state of a device in a process industry as claimed in claim 1, **characterized in that** after obtaining the correlated state dimensions, the method further comprises:
outputting the obtained correlated state dimensions to a user, and if receiving modification information input by the user about the correlated state dimensions, modifying the correlated state dimensions according to the modification information.

4. The method for monitoring the state of a device in a process industry as claimed in claim 1, **characterized in that** after obtaining the device state reference model, the method further comprises:
outputting the obtained device state reference model to a user, and if receiving modification information input by the user about the device state reference model, modifying the device state reference model according to the modification information.

5. The method for monitoring the state of a device in a process industry as claimed in claim 1, **characterized in that** the correlation analysis algorithm is the Pearson correlation algorithm and/or the Kendall correlation algorithm, and
the algorithm for establishing a device state reference model is the Dirichlet process algorithm based on the Gaussian mixture model.

6. An apparatus (20) for monitoring the state of a device in a process industry, **characterized in that** the apparatus comprises:
a data acquisition module (21), configured for collecting and saving data of multi-dimensional states of a device in the process industry,
a correlation calculation module (22), configured for adopting a preset correlation analysis algorithm to perform a correlation analysis of the data collected by the data acquisition module (21) of the multi-dimensional states of the device to obtain correlated state dimensions, wherein a dimensional state is used as a target state and the correlation analysis algorithm is used to analyze which of the dimensional states are correlated to the target state,
a state reference model establishment module (23), configured for acquiring history data of correlated dimensional states from the data acquisition module (21) according to the correlated state dimensions obtained by the correlation calculation module (22) and adopting a preset algorithm to model the acquired history data of correlated dimensional states to obtain a device state reference model, and
an online monitoring module (24), configured for acquiring real-time data of correlated dimensional states of the device state reference model in real time from the data acquisition module (21) according to the device state reference model established by the state reference model establishment module (23) and determining whether a current state of the device is normal wherein, if the difference between a data value of a target state calculated according to the device state reference model from the real-time data and an actual target state data value is less than a preset threshold, the target state is considered normal, otherwise, the target state is abnormal.

7. The apparatus (20) for monitoring the state of a device in a process industry as claimed in claim 6, **characterized in that** the data acquisition module (21) collecting and saving data of the multi-dimensional states of a device in a process industry is specifically used to:
collect data of the multi-dimensional states of the device in the process industry from one or any combination of a manufacturing data acquisition system, a supervisory control and data acquisition system and a simulation system, and a device design system and save the data.

8. The apparatus (20) for monitoring the state of a device in a process industry as claimed in claim 6, **characterized in that** the apparatus (20) further comprises a man-machine interaction module (25), and
the correlation calculation module (22) is further configured to output the obtained correlated state dimensions to a user through the man-machine interaction module (25), and if receiving modification information input by the user about the correlated state dimensions from the man-machine interaction module (25), modify the correlated state dimensions according to the modification information.

9. The apparatus (20) for monitoring the state of a device in a process industry as claimed in claim 6, **characterized in that** the apparatus (20) further comprises a man-machine interaction module (25), and
the state reference establishment module (23) is further configured to output the obtained device state reference model to a user through the man-machine interaction module (25), and if receiving modification information input by the user about the device state reference model from the man-machine interaction module (25), modify the device state reference model according to the modification information.

10. A computer readable storage medium, storing a computer program, **characterized in that** the computer program performs the steps of the method for monitoring the state of a device in a process industry as claimed in any of claims 1 to 5 when executed by a processor.

11. A computer program for monitoring the state of a device in a process industry, which, when executed by a computer, cause the computer to carry out the steps of the method of any one of claims 1 to 5.

## Patentansprüche

1. Verfahren zur Überwachung des Zustands einer Vorrichtung in einer Prozessindustrie, **dadurch gekennzeichnet, dass** das Verfahren Folgendes umfasst:
Sammeln und Speichern (S101) von Daten von mehrdimensionalen Zuständen einer Vorrichtung in der Prozessindustrie;
Anwenden (S102) eines voreingestellten Korrelationsanalysealgorithmus, um eine Korrelationsanalyse der gesammelten Daten der mehrdimensionalen Zustände der Vorrichtung durchzuführen, um einen korrelierten dimensionalen Zustand zu erhalten, wobei ein dimensionaler Zustand als ein Zielzustand verwendet wird und der Korrelationsanalysealgorithmus verwendet wird, um zu analysieren, welcher der dimensionalen Zustände mit dem Zielzustand korreliert ist;
Erfassen (S103) von Verlaufsdaten von korrelierten dimensionalen Zuständen gemäß den erhaltenen korrelierten Zustandsdimensionen;
Anwenden (S103) eines voreingestellten Algorithmus zum Modellieren der erfassten Verlaufsdaten von korrelierten dimensionalen Zuständen, um ein Vorrichtungszustandsreferenzmodell zu erhalten;
Erfassen (S104) von Echtzeitdaten von korrelierten dimensionalen Zuständen des Vorrichtungszustandsreferenzmodells in Echtzeit; und
Bestimmen (S104), ob ein aktueller Zustand der Vorrichtung normal ist, wobei, falls die Differenz zwischen einem Datenwert eines Zielzustands, der gemäß dem Vorrichtungszustandsreferenzmodell aus den Echtzeitdaten berechnet wird, und einem tatsächlichen Zielzustandsdatenwert kleiner als ein voreingestellter Schwellenwert ist, der Zielzustand als normal angesehen wird, andernfalls der Zielzustand anormal ist.

2. Verfahren zur Überwachung des Zustands einer Vorrichtung in einer Prozessindustrie nach Anspruch 1, **dadurch gekennzeichnet, dass** der Schritt des Sammelns und Speicherns (S101) von Daten der mehrdimensionalen Zustände einer Vorrichtung in einer Prozessindustrie Folgendes umfasst:
Sammeln von Daten der mehrdimensionalen Zustände der Vorrichtung in der Prozessindustrie von einem oder einer beliebigen Kombination aus einem Fertigungsdatenerfassungssystem, einem Überwachungssteuerungs- und Datenerfassungssystem und einem Simulationssystem und einem Vorrichtungsdesignsystem und Speichern der Daten.

3. Verfahren zur Überwachung des Zustands einer Vorrichtung in einer Prozessindustrie nach Anspruch 1, **dadurch gekennzeichnet, dass** das Verfahren nach dem Erhalten der korrelierten Zustandsdimensionen ferner Folgendes umfasst: Ausgeben der erhaltenen korrelierten Zustandsdimensionen an einen Benutzer und, falls durch den Benutzer eingegebene Modifikationsinformationen über die korrelierten Zustandsdimensionen empfangen werden, Modifizieren der korrelierten Zustandsdimensionen gemäß den Modifikationsinformationen.

4. Verfahren zur Überwachung des Zustands einer Vorrichtung in einer Prozessindustrie nach Anspruch 1, **dadurch gekennzeichnet, dass** das Verfahren nach dem Erhalten des Vorrichtungszustandsreferenzmodells ferner Folgendes umfasst: Ausgeben des erhaltenen Vorrichtungszustandsreferenzmodells an einen Benutzer und, falls durch den Benutzer eingegebene Modifikationsinformationen über das Vorrichtungszustandsreferenzmodell empfangen werden, Modifizieren des Vorrichtungszustandsreferenzmodells gemäß den Modifikationsinformationen.

5. Verfahren zur Überwachung des Zustands einer Vorrichtung in einer Prozessindustrie nach Anspruch 1, **dadurch gekennzeichnet, dass** der Korrelationsanalysealgorithmus der Pearson-Korrelationsalgorithmus und/oder der Kendall-Korrelationsalgorithmus ist und
der Algorithmus zum Erstellen eines Vorrichtungszustandsreferenzmodells der Dirichlet-Prozessalgorithmus ist, der auf dem Gaußschen Mischmodell basiert.

6. Einrichtung (20) zum Überwachen des Zustands einer Vorrichtung in einer Prozessindustrie, **dadurch gekennzeichnet, dass** die Einrichtung Folgendes umfasst:
ein Datenerfassungsmodul (21), das zum Sammeln und Speichern von Daten von mehrdimensionalen Zuständen einer Vorrichtung in der Prozessindustrie ausgelegt ist,
ein Korrelationsberechnungsmodul (22), das zum Anwenden eines voreingestellten Korrelationsanalysealgorithmus ausgelegt ist, um eine Korrelationsanalyse der durch das Datenerfassungsmodul (21) gesammelten Daten der mehrdimensionalen Zustände der Vorrichtung durchzuführen, um korrelierte Zustandsdimensionen zu erhalten, wobei ein dimensionaler Zustand als ein Zielzustand verwendet wird und der Korrelationsanalysealgorithmus verwendet wird, um zu analysieren, welcher der dimensionalen Zustände mit dem Zielzustand korreliert ist,
ein Zustandsreferenzmodell-Erstellungsmodul (23), das zum Erfassen von Verlaufsdaten von korrelierten dimensionalen Zuständen von dem Datenerfassungsmodul (21) gemäß den korrelierten Zustandsdimensionen, die durch das Korrelationsberechnungsmodul (22) erhalten werden, und Anwenden eines voreingestellten Algorithmus zum Modellieren der erfassten Verlaufsdaten von korrelierten dimensionalen Zuständen ausgelegt ist, um ein Vorrichtungszustandsreferenzmodell zu erhalten, und
ein Online-Überwachungsmodul (24), das zum Erfassen von Echtzeitdaten von korrelierten dimensionalen Zuständen des Vorrichtungszustandsreferenzmodells in Echtzeit von dem Datenerfassungsmodul (21) gemäß dem Vorrichtungszustandsreferenzmodell, das durch das Zustandsreferenzmodell-Erstellungsmodul (23) erstellt wird, und Bestimmen ausgelegt ist, ob ein aktueller Zustand der Vorrichtung normal ist, wobei, falls die Differenz zwischen einem Datenwert eines Zielzustands, der gemäß dem Vorrichtungszustandsreferenzmodell aus den Echtzeitdaten berechnet wird, und einem tatsächlichen Zielzustandsdatenwert kleiner als ein vorgegebener Schwellenwert ist, der Zielzustand als normal angesehen wird, andernfalls der Zielzustand anormal ist.

7. Einrichtung (20) zum Überwachen des Zustands einer Vorrichtung in einer Prozessindustrie nach Anspruch 6, **dadurch gekennzeichnet, dass** das Datenerfassungsmodul (21), das Daten der mehrdimensionalen Zustände einer Vorrichtung in einer Prozessindustrie sammelt und speichert, insbesondere zu Folgendem verwendet wird:
Sammeln von Daten der mehrdimensionalen Zustände der Vorrichtung in der Prozessindustrie von einem oder einer beliebigen Kombination aus einem Fertigungsdatenerfassungssystem, einem Überwachungssteuerungs- und Datenerfassungssystem und einem Simulationssystem und einem Vorrichtungsdesignsystem und Speichern der Daten.

8. Einrichtung (20) zum Überwachen des Zustands einer Vorrichtung in einer Prozessindustrie nach Anspruch 6, **dadurch gekennzeichnet, dass** die Einrichtung (20) ferner ein Mensch-Maschine-Interaktionsmodul (25) umfasst, und
das Korrelationsberechnungsmodul (22) ferner dazu ausgelegt ist, die erhaltenen korrelierten Zustandsdimensionen über das Mensch-Maschine-Interaktionsmodul (25) an einen Benutzer auszugeben und, falls durch den Benutzer eingegebene Modifikationsinformationen über die korrelierten Zustandsdimensionen von dem Mensch-Maschine-Interaktionsmodul (25) empfangen werden, die korrelierten Zustandsdimensionen gemäß den Modifikationsinformationen zu modifizieren.

9. Einrichtung (20) zum Überwachen des Zustands einer Vorrichtung in einer Prozessindustrie nach Anspruch 6, **dadurch gekennzeichnet, dass** die Einrichtung (20) ferner ein Mensch-Maschine-Interaktionsmodul (25) umfasst, und
das Zustandsreferenzerstellungsmodul (23) ferner dazu ausgelegt ist, das erhaltene Vorrichtungszustandsreferenzmodell über das Mensch-Maschine-Interaktionsmodul (25) an einen Benutzer auszugeben und, falls durch den Benutzer eingegebene Modifikationsinformationen über das Vorrichtungszustandsreferenzmodell von dem Mensch-Maschine-Interaktionsmodul (25) empfangen werden, das Vorrichtungszustandsreferenzmodell gemäß den Modifikationsinformationen zu modifizieren.

10. Computerlesbares Speichermedium, das ein Computerprogramm speichert, **dadurch gekennzeichnet, dass** das Computerprogramm die Schritte des Verfahrens zur Überwachung des Zustands einer Vorrichtung in einer Prozessindustrie nach einem der Ansprüche 1 bis 5 ausführt, wenn es durch einen Prozessor ausgeführt wird.

11. Computerprogramm zum Überwachen des Zustands einer Vorrichtung in einer Prozessindustrie, das bei Ausführung durch einen Computer den Computer veranlasst, die Schritte des Verfahrens nach einem der Ansprüche 1 bis 5 auszuführen.

## Revendications

1. Procédé de surveillance de l'état d'un dispositif dans une industrie de transformation, **caractérisé en ce que** le procédé comprend les étapes suivantes :
collecter et sauvegarder (S101) des données d'états multidimensionnels d'un dispositif dans l'industrie de transformation ;
adopter (S102) un algorithme d'analyse de corrélation prédéfini pour effectuer une analyse de corrélation des données collectées des états multidimensionnels du dispositif afin d'obtenir un état dimensionnel corrélé, où un état dimensionnel est utilisé comme état cible et l'algorithme d'analyse de corrélation est utilisé pour analyser lesquels des états dimensionnels sont corrélés à l'état cible ;
acquérir (S103) des données historiques d'états dimensionnels corrélés en fonction des dimensions d'état corrélées obtenues ;
adopter (S103) un algorithme prédéfini pour modéliser les données historiques acquises d'états dimensionnels corrélés afin d'obtenir un modèle de référence d'état de dispositif ;
acquérir (S104) des données en temps réel d'états dimensionnels corrélés du modèle de référence d'état de dispositif en temps réel ; et
déterminer (S104) si l'état courant du dispositif est normal où, si la différence entre une valeur de données d'un état cible calculée selon le modèle de référence d'état de dispositif à partir des données en temps réel et une valeur de données de l'état cible réel est inférieure à un seuil prédéfini, l'état cible est considéré comme normal ; dans le cas contraire, l'état cible est anormal.

2. Procédé de surveillance de l'état d'un dispositif dans une industrie de transformation selon la revendication 1, **caractérisé en ce que** l'étape de collecte et de sauvegarde (S101) des données des états multidimensionnels d'un dispositif dans une industrie de transformation comprend les étapes suivantes : collecter des données sur les états multidimensionnels du dispositif dans l'industrie de transformation à partir d'une ou de toute combinaison d'un système d'acquisition de données de fabrication, d'un système de contrôle de surveillance et d'acquisition de données, d'un système de simulation et d'un système de conception de dispositif, et sauvegarder les données.

3. Procédé de surveillance de l'état d'un dispositif dans une industrie de traitement tel que revendiqué dans la revendication 1, **caractérisé en ce que**, après avoir obtenu les dimensions d'état corrélées, le procédé comprend en outre les étapes suivantes :
envoyer les dimensions d'état corrélées obtenues à un utilisateur et, en cas de réception d'informations de modification introduites par l'utilisateur concernant les dimensions d'état corrélées, modifier les dimensions d'état corrélées en fonction des informations de modification.

4. Procédé de surveillance de l'état d'un dispositif dans une industrie de transformation tel que revendiqué dans la revendication 1, **caractérisé en ce que**, après avoir obtenu le modèle de référence d'état de dispositif, le procédé comprend en outre les étapes suivantes :
délivrer en sortie le modèle de référence d'état de dispositif obtenu vers un utilisateur et, en cas de réception d'informations de modification introduites par l'utilisateur concernant le modèle de référence d'état de dispositif, modifier le modèle de référence d'état de dispositif en fonction des informations de modification.

5. Procédé de surveillance de l'état d'un dispositif dans une industrie de transformation tel que revendiqué dans la revendication 1, **caractérisé en ce que** l'algorithme d'analyse de corrélation est l'algorithme de corrélation de Pearson et/ou l'algorithme de corrélation de Kendall, et
l'algorithme d'établissement d'un modèle de référence d'état de dispositif est l'algorithme du processus de Dirichlet basé sur le modèle de mélange gaussien.

6. Appareil (20) de surveillance de l'état d'un dispositif dans une industrie de transformation, **caractérisé en ce que** l'appareil comprend :
un module d'acquisition de données (21), configuré pour collecter et sauvegarder des données d'états multidimensionnels d'un dispositif dans l'industrie de transformation,
un module de calcul de corrélation (22), configuré pour adopter un algorithme d'analyse de corrélation prédéfini afin d'effectuer une analyse de corrélation des données collectées par le module d'acquisition de données (21) des états multidimensionnels du dispositif pour obtenir des dimensions d'état corrélées, un état dimensionnel étant utilisé comme état cible et l'algorithme d'analyse de corrélation étant utilisé pour analyser lesquels des états dimensionnels sont corrélés à l'état cible,
un module d'établissement de modèle de référence d'état (23), configuré pour acquérir des données historiques d'états dimensionnels corrélés à partir du module d'acquisition de données (21) en fonction des dimensions d'état corrélées obtenues par le module de calcul de corrélation (22) et adopter un algorithme prédéfini pour modéliser les données historiques acquises d'états dimensionnels corrélés afin d'obtenir un modèle de référence d'état de dispositif, et
un module de surveillance en ligne (24), configuré pour acquérir des données en temps réel d'états dimensionnels corrélés du modèle de référence d'état de dispositif en temps réel à partir du module d'acquisition de données (21) selon le modèle de référence d'état de dispositif établi par le module d'établissement de modèle de référence d'état (23) et pour déterminer si l'état courant du dispositif est normal, où, si la différence entre une valeur de données d'un état cible calculée selon le modèle de référence d'état de dispositif à partir des données en temps réel et une valeur de données d'état cible réel est inférieure à un seuil prédéfini, l'état cible est considéré comme normal, sinon, l'état cible est anormal.

7. Appareil (20) de surveillance de l'état d'un dispositif dans une industrie de transformation tel que revendiqué dans la revendication 6, **caractérisé en ce que** le module d'acquisition de données (21) collectant et sauvegardant les données des états multidimensionnels d'un dispositif dans une industrie de transformation est spécifiquement utilisé pour :
collecter des données sur les états multidimensionnels du dispositif dans l'industrie de transformation à partir d'une ou de toute combinaison d'un système d'acquisition de données de fabrication, d'un système de contrôle de surveillance et d'acquisition de données, d'un système de simulation et d'un système de conception de dispositif, et sauvegarder les données.

8. Appareil (20) de surveillance de l'état d'un dispositif dans une industrie de transformation tel que revendiqué dans la revendication 6, **caractérisé en ce que** l'appareil (20) comprend en outre un module d'interaction homme-machine (25), et **en ce que**
le module de calcul de corrélation (22) est en outre configuré pour délivrer en sortie les dimensions d'état corrélées obtenues à un utilisateur par l'intermédiaire du module d'interaction homme-machine (25) et, en cas de réception des informations de modification entrées par l'utilisateur au sujet des dimensions d'état corrélées depuis le module d'interaction homme-machine (25), pour modifier les dimensions d'état corrélées en fonction des informations de modification.

9. Appareil (20) de surveillance de l'état d'un dispositif dans une industrie de transformation tel que revendiqué dans la revendication 6, **caractérisé en ce que** l'appareil (20) comprend en outre un module d'interaction homme-machine (25), et **en ce que**
le module d'établissement de référence d'état (23) est en outre configuré pour délivrer en sortie le modèle de référence d'état de dispositif obtenu à un utilisateur par l'intermédiaire du module d'interaction homme-machine (25) et, en cas de réception des informations de modification introduites par l'utilisateur concernant le modèle de référence d'état de dispositif depuis le module d'interaction homme-machine (25), pour modifier le modèle de référence d'état de dispositif en fonction des informations de modification.

10. Support de stockage lisible par ordinateur, stockant un programme d'ordinateur, **caractérisé en ce que** le programme d'ordinateur exécute les étapes du procédé de surveillance de l'état d'un dispositif dans une industrie de traitement tel que revendiqué dans l'une quelconque des revendications 1 à 5, lorsqu'il est exécuté par un processeur.

11. Programme d'ordinateur pour la surveillance de l'état d'un dispositif dans une industrie de traitement qui, lorsqu'il est exécuté par un ordinateur, amène l'ordinateur à exécuter les étapes du procédé de l'une quelconque des revendications 1 à 5.
